# EUROPEAN PATENT APPLICATION

(11) **EP 1 130 637 A1**
(43) Date of publication of application: **05.09.2001**
(21) Application number: 00830163.2
(22) Date of filing: 03.03.2000
(51) Int. Cl.: H01L 21/48

(54) **A method of removing moulding residues during the manufacture of plastic packages for semiconductor devices**

(71) Applicant: STMicroelectronics S.r.l., 20041 Agrate Brianza MI (IT); Arges GmbH, 92507 Nabburg (DE)
(72) Inventor: Crema, Paolo, 20059 Vimercate (Milano) (IT); Guggenmos, Markus, 92421 Schwandorf (DE)
(74) Representative: Maccalli, Marco

(57) **Abstract**

A method of removing plastic residues (14) from metal parts (11, 12) of plastic packages for semiconductor devices, that is, dissipators and terminals, provides for the subjection of the surfaces to be treated to a first pulsed laser radiation (27) with a first wavelength selected such that the residues with thicknesses greater than a predetermined value absorb the first radiation (27), the intensity and the period of application of the first radiation being selected such that the residues of greater thickness are attacked by the first radiation, and a second pulsed laser radiation (26) with a second wavelength selected such that the residues with thicknesses less than the predetermined value are at least partially transparent to the radiation and that the metal parts are at least partially absorbent in relation to the second radiation, the intensity and the period of application of the second radiation being selected such that the radiation causes the formation of plasma at the point of impact with the metal part.

## Description

The present invention relates to the manufacture of semiconductor devices and, more particularly, to a method of removing residues of moulding material from metal parts of plastic packages for semiconductor devices.

As is known, many power semiconductor devices (discrete transistors and integrated circuits) are enclosed in packages each constituted basically by a plastic body, by conductor terminals projecting from the plastic body, and by a metal plate. The latter has the function of dissipating the heat produced by the device during its operation or for promoting the transfer of heat to the exterior and is usually mounted in contact with a flat surface of an external radiator of large dimensions.

In order to manufacture a device of this type, a chip of semiconductor material is fixed to the metal plate which acts as a dissipator; a metal framework is then mounted on the plate, electrically insulated therefrom; the framework, which is produced by blanking from a sheet metal, comprises metal strips, which are intended to become the terminals of the device, and interconnecting portions between the strips; thin wires are soldered at one end to suitable areas of the chip and at the other end to the ends of the metal strips. The resulting structure is mounted, together with other identical structures, in a suitable mould with one face of the dissipator in contact with a flat surface of the mould. A plastic material, for example, a thermosetting epoxy resin, is then introduced into the mould in the liquid state. After polymerization of the resin, a solid plastic body is removed from the mould and incorporates the entire structure except for the face of the dissipator, which remained in contact with the flat surface of the mould, and parts of the metal strips and of the interconnecting portions between them. The latter are removed by blanking at a subsequent processing stage.

During the moulding operation, in many cases, the liquid resin penetrates between the dissipator and the mould because of small irregularities of one or other of the surfaces in contact, for example, due to a slight curvature of the dissipator or to wear of the mould. After removal from the mould, the package may therefore have residues of moulding material, that is, of set resin, on the dissipator. Similar infiltrations may occur on the metal strips with the consequent formation of residues on these also, particularly in the vicinity of the plastic body.

The plastic residues on the dissipator have to be removed because, otherwise, they would reduce the area of contact with an external radiator or with a metal plate of a printed circuit to which the dissipator is to be soldered. The residues on the terminals also have to be removed because they obstruct the blanking of the interconnecting portions and the subsequent operation of bending of the terminals.

Various methods are known for removing the residues of moulding material. For example, there are known electrical or chemical treatments which can advantageously be used on the terminals but which are not suitable for use on the dissipators. There are also known sand-blasting treatments which enable even thick residues to be removed from the dissipator and from the terminals but, owing to their high-energy mechanical action, are not suitable for use in the treatment of small plastic packages with very thin terminals very close together.

Prior European patent application No. EP-A-0905762 describes a method of removing residues of moulding material from metal parts of plastic packages for semiconductor devices which provides for the use of a neodymium YAG laser with a doubled frequency, which thus produces laser radiation having a wavelength of 532 nm, corresponding to visible green light and suitably pulsed. The radiation is directed in a controllable manner onto the regions of the dissipator and of the terminals which are covered by plastic residues. Upon each pulse of the laser radiation, plasma is produced, with consequent vaporization of the residues. The removal of the residues does not take place as a direct result of the radiation thereon but is mediated by the underlying metal which is highly absorbent in relation to this wavelength. This causes the formation of plasma at the interface with the metal, which vaporizes the overlying organic material constituting the residues.

However, the above-mentioned method can be implemented effectively in the industrial process only for very thin residues of moulding material which have thicknesses of 5 - 8 µm and in any case no greater than 10 µm and which are partially transparent to laser radiation at 532 nm. In fact it is only in this way that the laser radiation reaches the underlying, highly absorbent metal and brings about the indispensable plasma formation. Since this radiation is absorbed to a limited extent by the organic material constituting the package, it does not damage the adjacent parts of the package.

If the residues of moulding material have a greater thickness, for example, of 20 µm or more, the above-mentioned method cannot be used since these "black" residues are highly absorbent in relation to all wavelengths but, since they are also thicker, require more energy per pulse or several pulses to remove them completely. This leads to excessive damage to the organic material constituting the package itself.

The object of the present invention is to provide a method of removing both thin residues of moulding material and residues of considerable thickness from metal parts of a plastic package, which method does not damage the plastic package, has a production capacity comparable to that of the method described above, and can also be used in the treatment of plastic packages with thin terminals.

This object is achieved by means of a method of removing residues of moulding material from metal parts of plastic packages for semiconductor devices, characterized in that at least one surface region of a metal part covered by residues of moulding material is subjected to:
a first pulsed laser radiation with a first wavelength selected such that the residues of moulding material with thicknesses greater than a predetermined value absorb the first radiation, the intensity and the period of application of the first radiation being selected such that the residues with greater thicknesses are attacked by the first radiation, and
a second pulsed laser radiation with a second wavelength selected such that residues of moulding material with thicknesses less than the predetermined value are at least partially transparent to the radiation and that the metal parts are at least partially absorbent in relation to the second radiation, the intensity and the period of application of the second radiation being selected such that the radiation causes the formation of plasma at the point of impact with the metal part.

The invention and the advantages resulting therefrom will become clear from the following description of an embodiment thereof, described by way of non-limiting example with reference to the appended drawings, in which:
Figure 1 is a perspective view of a plastic package as it appears after moulding, and
Figure 2 shows the package of Figure 1, in section, and an apparatus for implementing the method of the invention, in diagrammatic form.

The package shown in the drawings comprises a body 10 of plastic material, for example, an epoxy resin with carbon particles as an additive, a plurality of conductor terminals 11, for example, made of copper or nickel-plated copper, and a metal plate 12, for example, made of copper or nickel-plated copper and having the function of dissipating heat and supporting a chip of semiconductor material which is not visible because it is entirely incorporated in the body of plastic material. The terminals 11 are joined together by interconnecting portions 13 which are to be removed by a subsequent blanking operation. Normally, at this stage of the processing, the terminals of the package are connected to the terminals of other packages formed by the same operation and with the same mould and are separated only during the subsequent blanking operation. However, in order not to make the drawing unnecessarily complex, the terminals of only one package are shown. For the same reason, a package with only ten terminals is shown. In many practical embodiments, there are many more terminals. For example, a typical package having a width of 12 mm, a length of 15 mm and a height of 3 mm has 36 terminals arranged in two rows of eighteen terminals, each 0.3 mm wide and 0.25 mm thick.

Residues 14 of plastic material due to infiltration of resin in the liquid state during moulding are shown on the face of the dissipator 12 which is to be mounted in contact with a flat metal element. These residues are in the form of more or less thin films of material. Since the carbon particles added to the resin usually have, for the most part, dimensions greater than 10 µm, when the film is very thin, that is, with a thickness of less than 10 µm, the carbon particles are in practice absent and the film is almost transparent to visible light. If, however, the film has a thickness greater than 10 µm, it contains carbon particles and is no longer transparent to visible light.

Residues 14 are also shown on some terminals, in the vicinity of the body 10.

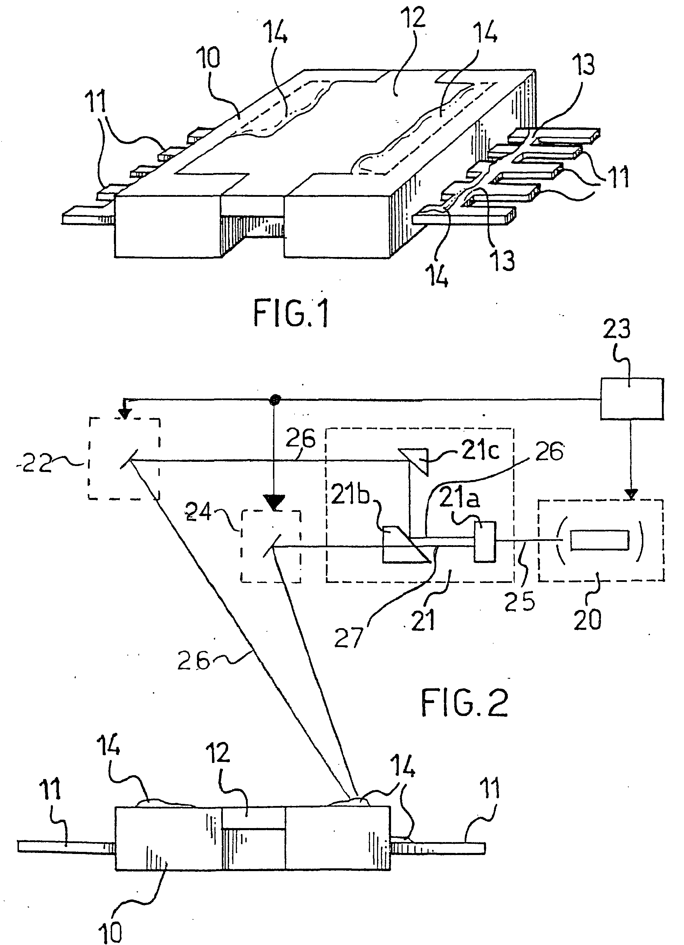

In Figure 2, the package of Figure 1 is shown in a side view with the plastic residues 14 shown with a deliberately exaggerated thickness for clarity of illustration. The apparatus for removing the plastic residues is constituted substantially by a laser 20, a frequency conversion unit 21 for selecting and deflecting the laser beam, a first optical scanning device 24, a second optical scanning device 22, and a synchronization unit 23.

In the embodiment of the method according to the invention which is described herein, the laser is preferably of the neodymium YAG type constituted basically by an yttrium and aluminium crystal doped with neodymium in the form of a rod which has mirrors at its ends and which emits a wavelength of 1,064 nm (infrared radiation) with pulses having a duration of between 6 and 8 ns and with an energy of about 800 mJoules per pulse. The frequency of repetition of the pulses is about 30 Hz. The beam 25 output by the laser 20 is supplied to a frequency converter 21a constituted by a KH₂PO₄ (potassium dideuterophosphate) crystal which, with a conversion efficiency of approximately 45%, provides an output beam 26 with a frequency of twice that of the input beam, that is, with half its wavelength, that is, 532 nm (visible green light). A dichroic mirror 21b separates the double frequency beam 26 from the residual beam 27 which has the output frequency of the laser 20. The laser beam 27, which has the output frequency of the laser 20, that is, the 1064 nm beam, is sent to the first scanning device 24 which is constituted by an optical system which can direct the 1064 nm laser beam 27 onto predetermined areas of the surface to be treated, that is, in this example, onto the regions of the dissipator 12 which are covered by plastic residues 14. The dichroic mirror 12b deflects the double-frequency beam 26, on the other hand, onto a mirror 21c which in turn deflects it towards the second scanning device 22. The latter is constituted by an optical system which can direct the 532 nm laser beam 26 in a controllable manner onto predetermined areas of the surface to be treated. The synchronization unit 23 controls the scanning devices 24, 22, selectively enabling them to operate, and synchronizes the emission of the laser pulses with the scanning. Naturally, a mirror similar to the mirror 21c may also be provided for the 1064 nm laser beam 27 if it is necessary to deflect this beam in order to direct it towards the first scanning device.

The synchronization unit 23 first enables the first scanning device 24 so that the 1064 nm laser beam 27 (infrared radiation) strikes the predetermined areas of the surface to be treated, that is, the regions covered by the plastic residues 14. The infrared radiation is absorbed very well by epoxy resin films having predominant thicknesses greater than 10 µm which are black because they contain carbon particles. Presumably because of its thermal radiation component, the infrared radiation attacks the material constituting the residues directly and has an intense effect on the plastic residues 14.

The synchronization unit 23 then enables the second scanning device 22 so that the 532 nm laser beam 26 (visible green light) strikes the predetermined areas of the surface to be treated. The thinner films of epoxy resin, particularly those with thicknesses of less than 10 µm, which do not contain carbon particles, have a transparency of approximately 20% and the metal used for the dissipator (copper) has an absorption of approximately 50%. The laser beam 26 has an intensity, that is, an energy per unit of surface area, such as to cause the formation of plasma upon each pulse. The plasma presumably originates from the transformation of the atoms of metal and of metal oxide which are on the surface of the dissipator struck by the high-intensity radiation. The formation of plasma is associated with vaporization of at least some of the residual material present on the impact area in a circular region of approximately 2 mm diameter. The application of the radiation in the visible green light range after the application of the infra-red radiation enables the metal constituting the dissipator and the terminals to be cleaned very efficiently.

The radiation in the visible green light range also has a direct attacking effect on the resin but this is negligible in comparison with the direct attack of the infra-red radiation. The visible green light alone cannot therefore clean the metal of plastic residues effectively.

Since the amount of material removed depends on the energy absorbed at the point of impact, the period of application of the radiation, both of the infra-red radiation and of the radiation in the visible green light range, that is, the number of pulses applied per unit of surface area, is metered according to the thickness of the residues to be removed. A single pass of the beam 27 followed by a pass of the beam 26 removes both thin residual plastic films (1-10 µm) and thicker films (10-50 µm).

According to a preferred embodiment of the method according to the invention, the surface of the dissipator 12 is scanned along two concentric curves. Along an outer curve substantially on the boundary with the body of plastic material (resin) 10, only the radiation in the visible green light range, which damages the resin of the body 10 only to a limited extent since it is not absorbed significantly by the resin itself, is used. Along an inner curve, spaced from the boundary with the body 10, the infra-red radiation is used, possibly followed by a scan along the same, inner curve with the radiation in the visible green light range. This prevents the infra-red radiation from falling on the body 10, which could damage the package.

Clearly, the method of the invention is equally suitable for removing plastic residues from the terminals. It should also be noted that this method does not cause any significant mechanical stress on the terminals, either, naturally, when it is used for treating the dissipator, or when it is used for treating the terminals, so that the terminals do not undergo any deformation during the process.

Although the foregoing description and the drawings relate merely to one embodiment of the invention, many variations and modifications are of course possible within the scope of the same inventive concept.

For example, laser devices of types other than that described above could be used.

Equally, it is not strictly necessary for the two types of radiation to be infra-red radiation and radiation in the visible green light range. In fact, more generally, there will be a first radiation with a wavelength suitable for being absorbed significantly by the thicker residual films of moulding material and for attacking them directly, and a second radiation with a wavelength to which the thinner residues of moulding material are transparent but which is such as to be absorbed by the underlying metal so as to enable plasma to be generated.

Moreover, although the same laser is preferably used to generate the two types of radiation, that is, the infra-red radiation and the radiation in the visible green light range, by means of frequency multiplying or dividing devices, clearly an alternative consists of the use of two different lasers with different output wavelengths. For example, for generating the second radiation, it would be possible to use a laser with krypton fluoride excimers which emits pulses of 25 ns width with a wavelength of 248 nm (ultraviolet), or pulsed lasers of other types, preferably with wavelengths of between 180 and 700 nm and with pulse widths of between 3 and 30 ns.

With regard to the use of two different scanning devices for the two types of radiation, naturally this does not constitute a limitation. If a scanning device which could deal with both types of laser radiation were available, it would clearly suffice for implementing the method according to the invention.

## Claims

1. A method of removing residues of moulding material from metal parts of plastic packages for semiconductor devices, characterized in that at least one surface region of a metal part (12) covered by residues (14) of moulding material is subjected to:
a first pulsed laser radiation (27) with a first wavelength selected such that the residues of moulding material (14) with thicknesses greater than a predetermined value absorb the first radiation (27), the intensity and the period of application of the first radiation being selected such that the residues of greater thickness are attacked by the first radiation directly, and
a second pulsed laser radiation (26) with a second wavelength selected such that the residues of moulding material (14) with thicknesses less than the predetermined value are at least partially transparent to the radiation and that the metal parts are at least partially absorbent in relation to the second radiation, the intensity and the period of application of the second radiation being selected such that the radiation causes the formation of plasma at the point of impact with the metal part.

2. A method according to Claim 1, characterized in that the first laser radiation (27) and the second laser radiation (26) are applied in sequence.

3. A method according to claim 1 or Claim 2, characterized in that a boundary region between the at least one surface region of the metal part (12) and a body (10) of the package is subjected exclusively to the second laser radiation (26).

4. A method according to any one of Claims 1, 2 and 3, in which the second laser radiation has a wavelength of between 180 and 700 nm.

5. A method according to any one of Claims 1, 2 and 3, characterized in that the first laser radiation (27) is in the infra-red range and the second laser radiation (26) is in the visible green light range.

6. A method according to Claim 5, characterized in that the first laser radiation (27) has a wavelength of approximately 1000 nm and the second laser radiation (26) has a wavelength of approximately 500 nm.

7. A method according to Claim 6, characterized in that the first laser radiation (27) is the output radiation of a neodymium YAG laser (20) and the second laser radiation (26) is produced from the first laser radiation by halving its wavelength.

8. A method according to any one of the preceding claims, in which the pulses of the laser radiation have a duration of between 3 and 30 ns.

9. A method according to any one of the preceding claims, in which the step of subjecting at least one surface region of a metal part to the first and second laser radiation comprises a scanning of the laser radiation over the surface region, and the period of application of the radiation is determined by the number of pulses of the radiation applied per unit of surface area.

10. A method according to Claim 9, in which the scanning movement is synchronized with the emission of the pulses.

11. A method according to any one of the preceding claims, used in the manufacture of plastic packages with metal parts (11, 12), in which the moulding material is an epoxy resin with carbon particles as an additive.

12. A method according to Claim 11, in which the carbon particles for the most part have dimensions greater than 10 µm, and in which the predetermined value of the thickness of the moulding material is approximately 10 µm.

13. A method according to any one of the preceding claims, in which the metal parts (11, 12) comprise copper parts.

14. A method according to any one of the preceding claims, in which the metal parts comprise nickel-plated copper parts.
